# EUROPEAN PATENT SPECIFICATION

(11) **EP 4 527 002 B1**
(45) Date of publication and mention of the grant of the patent: **11.02.2026**
(21) Application number: 23742460.1
(22) Date of filing: 30.06.2023
(51) Int. Cl.: H05K 1/02, H05K 1/03, H03K 17/12, H01L 23/498, H01L 25/07, H01L 25/16

(54) **SMALL FOOTPRINT POWER SWITCH**
LEISTUNGSSCHALTER MIT KLEINER STANDFLÄCHE
COMMUTATEUR DE PUISSANCE POUR PETITE EMPREINTE

(30) Priority: 07.07.2022 US 202263358886 P
(43) Date of publication of application: 26.03.2025
(73) Proprietor: Visic Technologies Ltd., Nes Ziona, 7403650 (IL)
(72) Inventor: ROMERO, Guillermo, Phoenix, Arizona 85044 (US); GRANOT, Oded, 3760122 Harish (IL); VEPRINSKY, Valery, 6706530 Tel Aviv (IL); STESSIN, Lev, 7849722 Ashkelon (IL)
(74) Representative: Prüfer & Partner mbB Patentanwälte · Rechtsanwälte
(86) International application number: PCT/IL2023/050683
(87) International publication number: WO 2024/009294

(56) References cited:
- WO-A1-2015/176985
- US-A1- 2017 093 302
- US-B2- 10 147 703
- US-B2- 10 347 533
- US-B2- 11 101 241
- EMON ASIF IMRAN ET AL: "Design and Optimization of Gate Driver Integrated Multichip 3-D GaN Power Module", IEEE TRANSACTIONS ON TRANSPORTATION ELECTRIFICATION, IEEE, vol. 8, no. 4, 6 May 2022 (2022-05-06), pages 4391 - 4407, XP011924554, [retrieved on 20220509], DOI: 10.1109/TTE.2022.3173585

## Description

### RELATED APPLICATIONS

The present application claims the benefit under 35 U.S.C. 119(e) of U.S. Provisional Application 63/358,886 filed on July 7, 2022.

### FIELD

Embodiments of the invention relate to a power switch. An example of a Prior Art power switch packaging is disclosed in US10147703 B2.

### BACKGROUND

Modern optical and electronic devices of almost all types, from computers to powertrains, comprise power switching circuitry for generating timing pulses, data packets, and/or delivering power. For delivering power to electric powertrains, such as powertrains used to deliver power to electric vehicles, power switches are required that can carry large currents and be turned ON and OFF rapidly to couple and decouple a high voltage electric power source to a load. For example, a high power inverter operated to deliver AC power to an automotive traction motor from a DC power source may comprise a half bridge having a high side array of GaN dies connected to a low side array of GaN dies, and a PCB control circuit to control the arrays to invert the DC power to AC power. It is advantageous that the inverter have low inductance, a small footprint, efficient heat dissipation, and be easily mountable and scalable to satisfy electrical and mechanical constraints of different electric vehicle configurations.

### SUMMARY

An aspect of an embodiment of the disclosure relates to providing a power switch, also referred to as a Power-Mite, characterized by low inductance and small footprint that is readily scalable and may easily be coupled to external electrical circuitry and mounted by soldering or sintering to a heatsink. In an embodiment Power-Mite comprises a pair of half bridges and a printed circuit board (PCB) controller operable to turn ON and turn OFF the half bridges to provide pulses of voltage and current to a load connected to Power-Mite. Each half bridge optionally comprises a high side GaN die connected to a low side GaN die. To provide Power-Mite with relatively low inductance, the half bridges are configured so that current flows in substantially same, parallel directions when the half bridges are turned ON to provide voltage and a pulse of current to the load. The total power loop inductance of Power-Mite during transition between ON and OFF states may be lower than about 2.5 nanoHenries (nH).

In an embodiment the half bridges, PCB controller, and other electrical and mechanical components of Power-Mite are encapsulated in a protective polymer encapsulation, optionally referred to as an envelope. The envelope has a substantially unbroken uniform geometric external shape comprising relatively large parallel planar face surfaces of a same shape and at least one relatively narrow edge surface. The envelope may by way of example substantially be a rectangular parallelopiped, a rectangular parallelopiped having face surfaces that are rounded parallelograms, or a solid having face surfaces that are squircles. In an embodiment terminals that provide electrical contact to a component or components inside the envelope are embedded in the envelope and have electrical contact surfaces for making electrical contact with the terminals that are located on a surface of the envelope. In an embodiment a terminal contact surface is substantially coplanar with a surface on which it lies. Optionally, the contact surface is recessed or raised with respect to the surface on which it is located. In an embodiment the contact surface is located on a face surface of the envelope. Optionally, the contract surfaces of all the terminals are located on a same face surface.

Power-Mite may comprise terminal pins that extend from an edge surface of the envelope for making electronic contact with a component or components inside the envelope. In an embodiment the terminal pins comprise terminal pins that are located diagonally opposite each other on opposite edge surfaces of the envelope.

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

### BRIEF DESCRIPTION OF THE FIGURES

Non-limiting examples of embodiments of the invention are described below with reference to figures attached hereto that are listed following this paragraph. Identical structures, elements or parts that appear in more than one figure are generally labeled with a same numeral in all the figures in which they appear. Dimensions of components and features shown in the figures are chosen for convenience and clarity of presentation and are not necessarily shown to scale.
Figs. 1A and 1B schematically show top and bottom perspective views of a Power-Mite power switch in accordance with an embodiment of the disclosure;
Fig. 1C schematically shows a variation of a Power-Mite in accordance with an embodiment of the disclosure;
Figs. 2A-2G schematically show features of the construction and assembly of a Power-Mite, in accordance with an embodiment of the disclosure; and
Figs. 3A-3C schematically compare footprints of an assembly of prior art power switches with assemblies of Power-Mites in accordance with embodiments of the disclosure.

### DETAILED DESCRIPTION

In the discussion, unless otherwise stated, adjectives such as "substantially" and "about" modifying a condition or relationship characteristic of a feature or features of an embodiment of the disclosure, are understood to mean that the condition or characteristic is defined to within tolerances that are acceptable for operation of the embodiment in an application for which it is intended. Wherever a general term in the disclosure is illustrated by reference to an example instance or a list of example instances, the instance or instances referred to, are by way of non-limiting example instances of the general term, and the general term is not intended to be limited to the specific example instance or instances referred to. The phrase "in an embodiment", whether or not associated with a permissive, such as "may", "optionally", or "by way of example", is used to introduce for consideration an example, but not necessarily required, configuration of possible embodiments of the disclosure. Each of the verbs, "comprise" "include" and "have", and conjugates thereof, are used to indicate that the object or objects of the verb are not necessarily a complete listing of components, elements or parts of the subject or subjects of the verb. Unless otherwise indicated, the word "or" in the description and claims is considered to be the inclusive "or" rather than the exclusive or, and indicates at least one of, or any combination of more than one of items it conjoins.

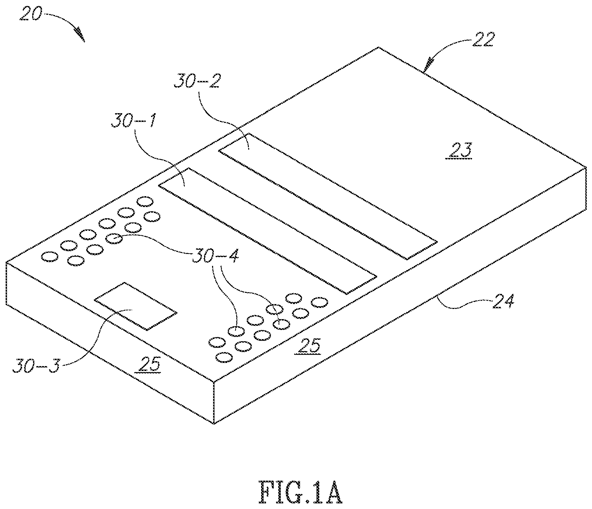

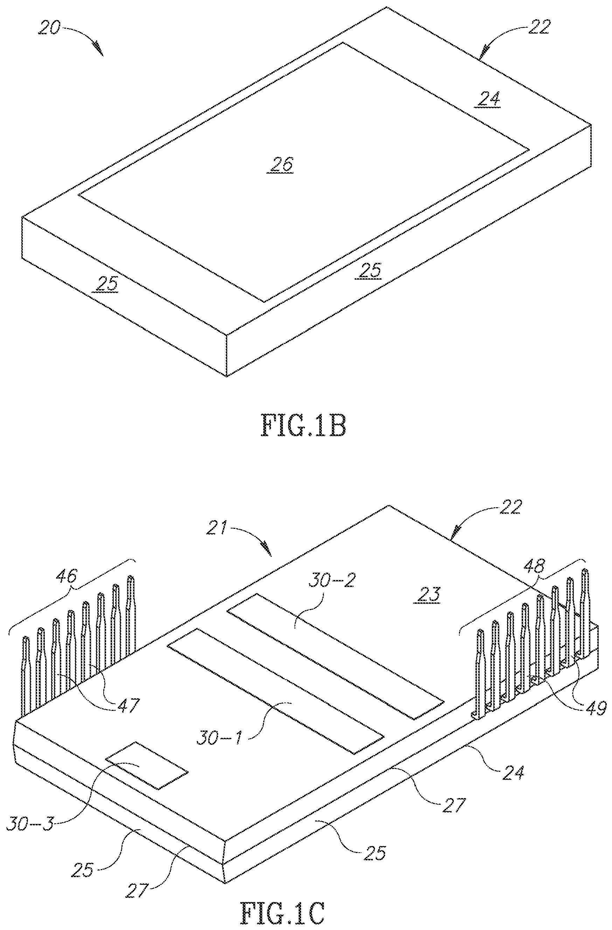

Figs. 1A and 1B schematically show top and bottom perspective views respectively of a Power-Mite 20 optionally configured to provide power to a phase of an electric vehicle traction motor, in accordance with an embodiment of the disclosure. Power-Mite 20 comprises an optionally rectangular parallelepiped envelope 22 having a top face surface 23 show in Fig. 1A, a bottom face surface 24 shown in Fig. 1B, and four relatively narrow edge surfaces 25. Envelope 22 may be formed as a result of dicing a plurality of Power-Mites 20 from a common multiunit encapsulation mold in which the Power-Mites are encapsulated in a suitable polymer.

Terminals (not shown in Figs. 1A and 1B) discussed below that provide contact to components of Power-Mite 20 are encapsulated in envelope 22 and have contact surfaces 30-1, 30-2, 30-3, and 30-4 that are exposed on top surface 23 and may be generically referenced as contact surfaces 30. Contact surfaces 30-1 and 30-2 are surfaces of power terminals 41 and 42 respectively discussed below that may be used to couple power from a high energy power source (not shown) to half bridges encapsulated in envelope 22. Contact surface 30-3 is a surface of a power phase output terminal 43 discussed below that may be used to couple voltage and current to a phase of an electric motor. Contact surfaces 30-4 are surfaces of control terminals 44 discussed below that may be used to couple control circuitry to a PCB controller discussed below encapsulated in envelope 22.

Optionally, contact surfaces 30, as schematically shown in Fig. 1A are coplanar, substantially flush, with top surface 23. In an embodiment a contact surface 30 may be raised or recessed to electrically isolate the contact surface and or facilitate making electrical contact with the contact surface. The contact surfaces 30 are formed from material that is compatible with electrically and mechanically coupling a conductor to the surfaces that is intended to provide electrical contact between an external circuit and the surfaces and the respective terminals of which the surfaces are a features. In an embodiment a surface 30 is configured so that a conductor may be electrically and mechanically coupled to a contact surface 30 by soldering, laser welding, or ultrasonic welding. Optionally, a surface 30 and its associated underlying terminal are configured so that a conductor may be screwed, or press fit into a hole formed in the terminal. Bottom surface 24 shown in Fig. 1B optionally has a conductive thermal interface 26 formed on the surface. The thermal interface may be way of example be formed from any of various suitable high heat conductive materials such as a thermally conductive solder or adhesive, a sintering or curing type silver paste.

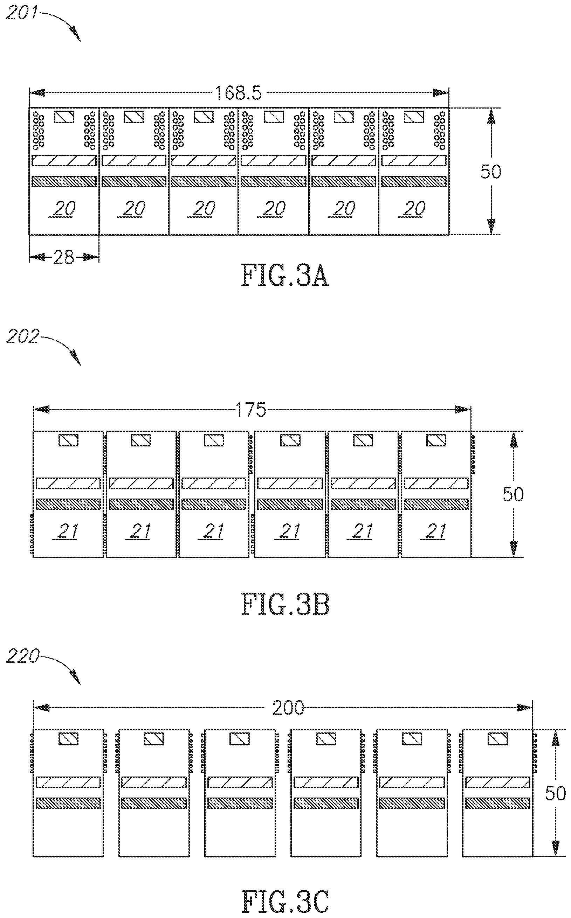

In an embodiment a Power-Mite 20 may comprise a terminal pin in addition to or in place of a contact surface 30. Fig. 1C schematically shows a Power-Mite 21 in accordance with an embodiment of the disclosure that is similar to Power-Mite 20 but comprising a set 46 of terminal pins 47 and a set 48 of terminal pins 49 in place of terminals having contact surfaces 30 on top face surface 23. In an embodiment, set 46 of terminal pins 47 and set 48 of terminal pins 49 are located diagonally opposite each other on opposite edge surfaces 25 of envelope 22. As discussed below with respect to Figs. 3A and 3B the location of terminal pin sets 46 and 48 diagonally opposite each other facilitates dense packing of a plurality of Power-Mites 20 and convenient connecting of the Power-Mites in parallel to provide switching large currents.

It is noted that envelope 22 in Fig. 1C exhibits a parting line 27 along which terminal pins are arrayed. Whereas it may be advantageous to encapsulate a plurality of Power-Mite 20 terminals, such as terminals 41-44 having contact surfaces 30, in a common multiunit encapsulation mold and then dice the Power-Mite 20 circuits to free the individual Power-Mite 20 circuits, it may be advantageous to encapsulate Power-Mite having terminal pins, such as terminal pins 47 and 49, individually in single unit molds. Whereas the process of multiunit encapsulation followed by dicing results in envelopes 22 absent parting lines, individual, single unit encapsulation generally requires a two piece release mold, which typically results in envelope 22 shown in Fig. 1C having parting lines 27.

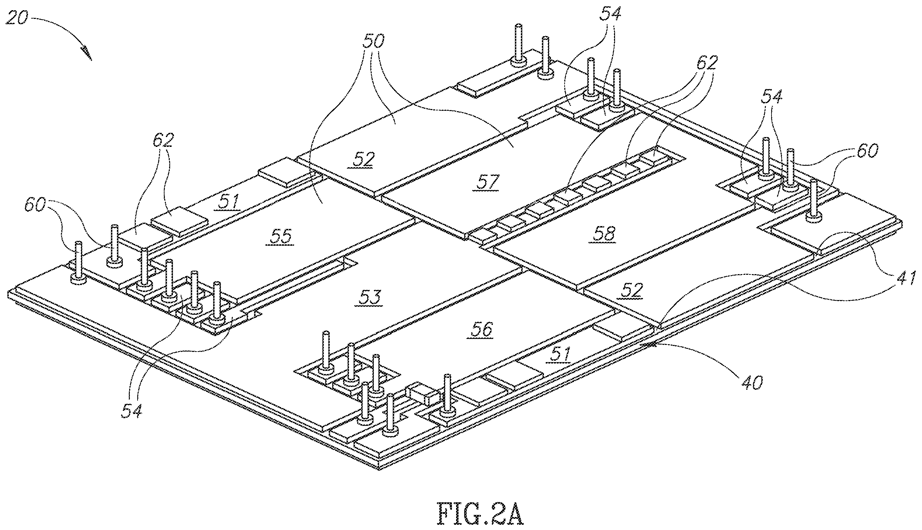

Figs. 2A-2G schematically show stages in the construction and assembly of Power-Mite 20, in accordance with an embodiment of the disclosure.

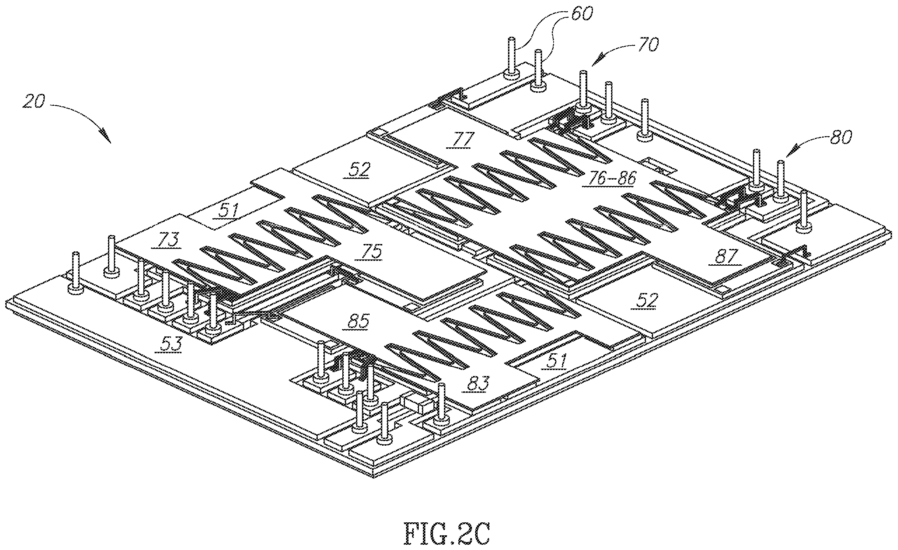

Fig. 2A schematically shows a first stage of the construction of a Power-Mite 20 in which a pattern of conductive traces generically referred to as traces 50 to which components of Power-Mite are to be electrically connected, is formed on an upper surface 41 of an optionally DBC (Direct bond copper) substrate 40. In an embodiment traces 50 comprise positive power terminal traces 51, negative power terminal traces 52, a power output phase trace 53, control traces 54, and die contact traces 55, 56, 57, and 58. Connecting pins 60 that may be used to electrically connect circuit components of Power-Mite to a PCB controller 100 (not shown in Fig. 2A) encapsulated in Power-Mite 20 are mounted to traces 50. In an embodiment conductive spacers 62 are electrically connected to power traces 51 to facilitate connection of the power traces to metallization electrodes of Power-Mite components. As schematically shown in Fig. 2C and discussed below, spacers 62 facilitate using planar interconnects to make electrical connections to metallization electrodes of Power-Mite components that are raised above top surfaces of traces 50 by thickness of the components.

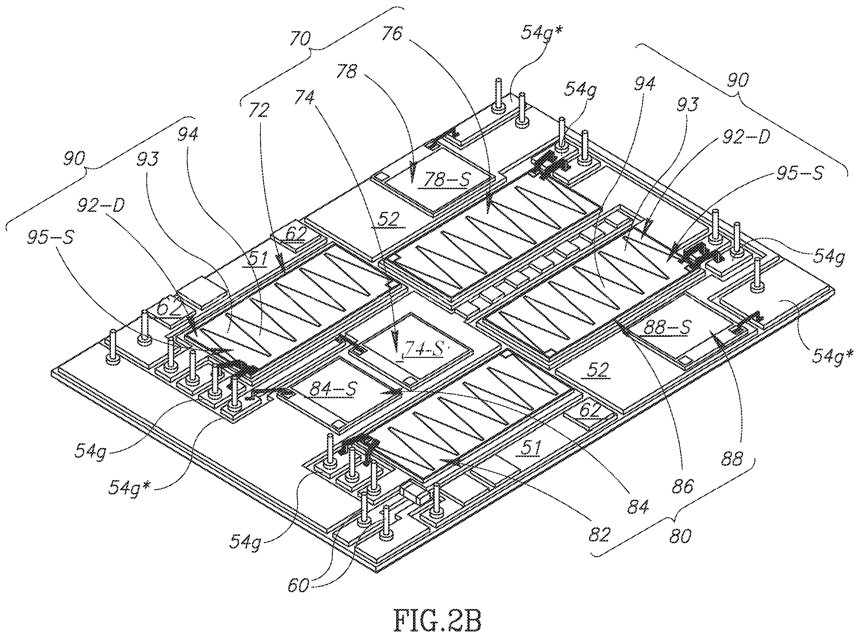

Fig. 2B schematically shows semiconductor dies that are directly connected to respective traces of traces 50 to form two half bridges 70 and 80 of Power-Mite 20. In an embodiment half bridge 70 comprises a high side, optionally normally ON lateral n-channel GaN (Gallium Nitride) die 72, a high side optionally p-channel MOSFET (Metal On Silicon Field Effect Transistor) die 74, a low side, optionally normally ON lateral n-channel GaN die 76 and a low side, optionally p-channel MOSFET die 78. Similarly half bridge 80 may comprise a high side, optionally normally ON lateral n-channel GaN die 82, a high side, optionally p-channel MOSFET die 84, and a low side, optionally normally ON lateral n-channel, GaN die 86, and a low side, optionally p-channel MOSFET die 88.

Each normally ON GaN die 72, 76, 82, and 86 optionally comprises an array (not shown) of rows of optionally normally ON lateral GaN transistors (not shown) connected to a fishbone configuration 90 of metallization layers comprising a drain fishbone metallization layer 92-D having spines 93 interleaved with spines 94 of a source fishbone metallization layer 95-S. Drains (not shown) of the normally ON GaN transistors are electrically contacted to spines 92-D of drain fishbone 93 and sources of the transistors are electrically contacted to spines 94 of the source fishbone 95-S. Gates of the GaN transistors are electrically connected to control traces 54 designated "54g" optionally by wire bonds. Gates of the MOSFET transistors are electrically connected to control traces 54 designated "54g*" optionally by wire bonds. The substrates (not shown) of GaN dies 72, 76, 82, and 86 are electrically connected to respective die traces 55, 57, 56, and 58 to which the dies are are mounted.

Each MOSFET die 74, 84, 78 and 88 comprises an array of MOSFET transistors (not shown) having their respective sources electrically connected to source metallization layers 74-S, 84-S, 78-S and 88-S respectively and their respective drains connected to a drain metallization layer (not shown). The drain metallization layers of high side MOSFET dies 74 and 84 are electrically connected to power output phase output trace 53. Each drain metallization layer of low side MOSFET dies 78 and 88 is electrically connected to a negative power trace 52.

In Fig. 2C the GaN dies and MOSFET dies shown in Fig. 2B are connected by relatively large area planar interconnect conductors. Drain fishbone metallization layer 92-D (Fig 2B) of high side GaN die 72 is electrically connected to conductive spacers 62 (Fig 2B) located on a positive power trace 51 by, an optionally planar, conductive interconnect 73. Source metallization 95-S (Fig 2B) of high side GaN die 72 is electrically connected to source metallization 74-S of high side MOSFET 70 by, an optionally planar, conductive interconnect 75. Similarly, drain metallization 92-D (Fig 2B) of high side GaN die 82 is electrically connected to conductive spacers 62 located and connected to a positive power trace 51 by, an optionally planar, conductive interconnect 83. Source metallization 95-S (Fig 2B) of high side GaN die 82 is electrically connected to source metallization 84-S of high side MOSFET 84 by, an optionally planar, conductive interconnect 85. Source metallization layer 95-S of low side Gan die 76 is electrically connected to source metallization layer 78-S of MOSFET 78 by, an optionally planar, interconnect 77 and source metallization layer 95-S of low side GAN die 86 is electrically connected to source metallization layer 88-S of MOSFET die 88 by, an optionally planar, interconnect 87. Drain metallization layers 92-D of low side GaN dies 76 and 86 are connected together by, an optionally planar, conductive interconnect 76-86. Interconnect 76-86 makes electrical contact with conductive spacers 62 on power output phase trace 53 and thereby with the power output phase trace.

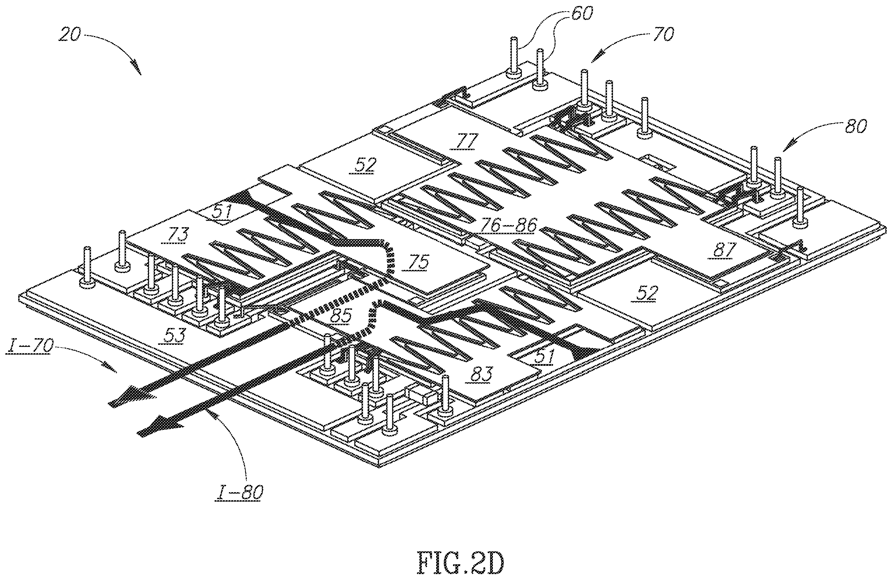

Fig. 2D schematically shows direction of current in half bridge 70 and half bridge 80 when Power-Mite 20 is ON and electrifies power trace 53 to deliver voltage and current to, optionally, a traction motor connected to Power-Mite 20 from a power source connected to positive and negative power terminal traces 51 and 52. In the figure, an arrowed band labeled I-70 schematically represents current flow that passes through half bridge 70. Solid portions of the band represent current flow of I-70 on interconnects 73, 75, and on conducting trace 53. A dashed region of band I-70 represents a "hidden" portion of I-70 that flows "down" from interconnect 75 through MOSFET 74 (Fig. 2B) to flow on a portion of conducting trace 53 beneath interconnects 75 and 85. Similarly an arrowed band labeled I-80 schematically represents current flow that passes through half bridge 80. Solid portions of the band represent current flow of I-80 on interconnects 83, 85, and on conducting trace 53. A dashed region of band I-80 represent a "hidden" portion of I-80 that flows "down" from interconnect 85 through MOSFET 84 (Fig. 2B) to flow on conducting trace 53 beneath interconnects 75 and 85. It is noted that currents I-70 and I-80 flow parallel to each other in trace 53 and contribute to reducing inductance of Power-Mite 20 during turn ON and turn OFF.

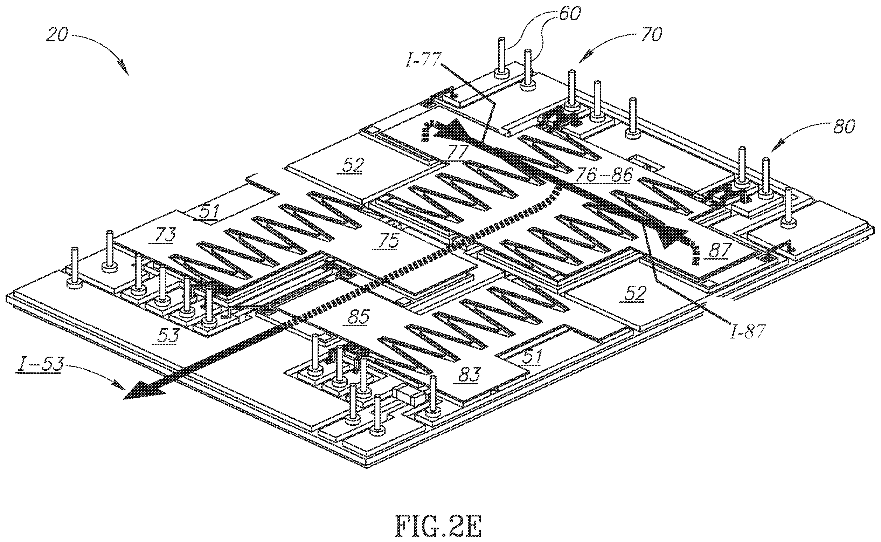

Fig. 2E schematically shows direction of current in half bridge 70 and half bridge 80 when Power-Mite 20 is turned OFF by turning high side GaN transistors 72 and 82 and MOSFETS 74 and 84 are turned OFF and low side Gan transistors 76 and 86 and low side MOSFETS 78 and 88 are turned ON. Current from negative power terminal trace 52 flows in current branches represented by bands I-77 and I-87 through MOSFETS 78 and 88 up to conductive interconnect 76-86 and combine in current represented by a current band I-53 to flow to Power-Mote 20 along output phase trace 53. Dashed portions of bands represent portions of current hidden in the perspective of Fig. 2E.

In an embodiment total power loop inductance of Power-Mite 20 during transition between ON and OFF states may be less than about 2.50 nH. Optionally the total power loop inductance may be less than about 2.25nH.

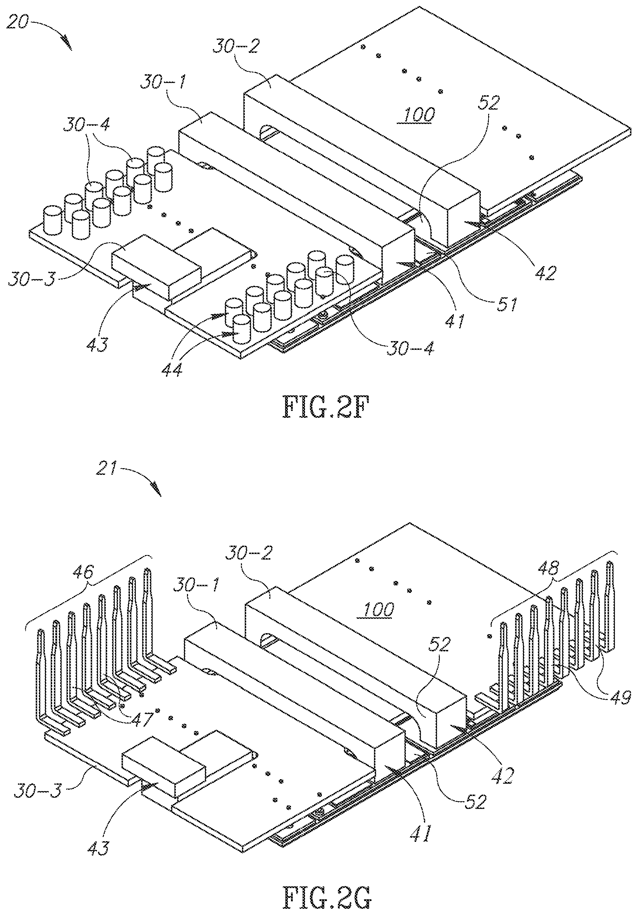

Fig. 2F schematically shows Power-Mite 20 after power terminals 41 and 42 having contact surfaces 30-1 and 30-2 (Fig. 1A) respectively are mounted to positive and negative power terminal traces 51 and 52 (Fig. 2A), power phase output terminal 43 having contact surface 30-3 (Fig. 1A) is mounted to power output phase trace 53 (Fig. 2A), and an optionally multilayer control PCB 100 has been mounted to Power-Mite 20. PCB 100 makes contact to components in Power-Mite 20 via connecting pins 60 (Figs. 2A-2E) and with circuitry outside of Power-Mite 20 via optionally cylindrical control terminals 44 having contact surfaces 30-4 (Fig. 1A). In an embodiment Power-Mite 20 as schematically shown in Fig. 2F is encapsulated to provide Power-Mite 20 in finished form as shown in Fig. 1A.

Fig. 2G schematically shows the Power-Mite variation, Power-Mite 21, in which cylindrical control terminals 44 shown in Fig. 2F are replaced by diagonally opposite sets 46 and 48 of terminal pins 47 and 49 respectively, and which after encapsulation has the configuration shown in Fig. 1C.

Power-Mites in accordance with an embodiment of the disclosure , such as Power-Mites 20 and 21 engineered as schematically shown in Figs. 1A-2G have unusually aesthetic configurations and relatively small footprints. The small footprints and embedded or diagonally opposite electrical terminals enable Power-Mites in accordance with embodiments of the disclosure to be readily mounted, optionally by soldering or sintering to a heatsink, and connected in parallel, in compact dense "power-pack" arrays.

By way of example, Figs. 3A and 3B schematically show dimensions of footprint of power-pack arrays 201 and 202 of six Power-Mites 20 and 21 respectively. In accordance with embodiments of the disclosure. For comparison, Fig. 3C shows a footprint of a power-pack 220, were terminal pin arrays mounted directly opposite, instead of diagonally opposite each other as in Power-Mite 21, in accordance with an embodiment. Footprints of power-pack arrays 201 and 202 are substantially smaller than that of footprint of power-pack array 220.

Descriptions of embodiments of the invention in the present application are provided by way of example and are not intended to limit the scope of the invention. The described embodiments comprise different features, not all of which are required in all embodiments of the invention. Some embodiments utilize only some of the features or possible combinations of the features. Variations of embodiments of the invention that are described, and embodiments of the invention comprising different combinations of features noted in the described embodiments, will occur to persons of the art. The scope of the invention is limited only by the claims.

## Claims

1. An electrical power switch (20) comprising:
a pair of substantially parallel half bridges (70, 80);
power terminals (41, 42) for coupling a power source to the half bridges;
a power phase output terminal (43) for connecting a load to the half bridges;
a printed circuit board (PCB) controller (100) having control circuitry operable to turn ON and turn OFF the half bridges to respectively connect and disconnect the load to the power source;
control terminals (44) for connecting the control circuitry on the PCB to circuitry external to the power switch;
wherein the half bridges, PCB, control terminals, power terminals, and power phase output terminal are encapsulated in a same encapsulation envelope (22) having planar first face surface (23) and at least one edge surface (25);
wherein all of the terminals have electrical contact surfaces (30-1, 30-2, 30-3, 30-4) that are exposed on and only on the first surface (23) and all of the at least one edge surface (25) are bare of electrical contact surfaces and terminal pins.

2. The electrical power switch according to claim 1, wherein the contact surfaces (30-1, 30-2, 30-3, 30-4) of the power terminals and power phase output terminal are substantially flush with the first face surface.

3. The electrical power switch according to claim 1 wherein an electrical contact surface of the power terminals (30-1, 30-2) and/or the power phase output terminal (30-3) is raised or recessed relative to the plane of the first face surface.

4. The electrical power switch according to any of claims 1-3, wherein the contact surfaces of the control terminals (30-4) are substantially flush with the first face surface (23).

5. The electrical power switch according to claim 4 wherein an electrical contact surface of a control terminal of the control terminals (30-4) is raised or recessed relative to the plane of the first face surface (23).

6. The electrical power switch according to any of claims 1-5 wherein the contact surface and the control terminal to which the surface belongs are configured to be coupled to an electrical conductor by soldering, ultrasonic or laser welding, or press fitting or screwing the conductor into a hole in the control terminal.

7. The electrical power switch according to any of claims 1-6 wherein the encapsulation envelope (22) is a rectangular parallelepiped that encapsulates all the components of the switch.

8. An electrical power switch (20) comprising:
a pair of substantially parallel half bridges (70, 80);
power terminals (41, 42) for coupling a power source to the half bridges;
a power phase output terminal (43) for connecting a load to the half bridges;
a printed circuit board (PCB) controller (100) having control circuitry operable to turn ON and turn OFF the half bridges to respectively connect and disconnect the load to the power source;
first and second sets (46, 48) of control terminal pins (48, 49) that make electrical contact with control circuitry on the PCB controller (100);
an encapsulation envelope (22) that encapsulates all the components of the switch with the exception of the control terminal pins (48, 49) and has a shape of a rectangular parallelepiped having a planar first face surface (23) and edge surfaces (25);
wherein, the contact surfaces (30-1, 30-2) of the power terminals (41, 42) are exposed on the first face surface, and the first and second sets (46, 48) of control terminal pins (48, 49) extend respectively from first and second opposite edge surfaces (25) at diagonally opposite locations so that normal projections of the sets onto a same plane parallel to the planes of the first and second edges do not overlap.

9. The electrical power switch according to any of the preceding claims and comprising a second face surface (24) opposite the first face surface and having formed thereon a conductive thermal interface (26).

10. The electrical power switch according to any of the preceding claims wherein when the switch is turned ON current flows to the power phase output terminal (43) parallel to a same direction in each half bridge (70, 80).

11. The electrical power switch according to any of the preceding claims and having a total power loop inductance when transitioning between ON and OFF states is less than about 2.5nH, or less than about 2.25 nH or less than about 2.0 nH.

12. A power pack array (201, 202) comprising a plurality of electrical power switches according to any of the preceding claims butted up against each other.

## Patentansprüche

1. Elektrischer Leistungsschalter (20), umfassend:
ein Paar im Wesentlichen paralleler Halbbrücken (70, 80);
Stromanschlüsse (41, 42) zum Koppeln einer Stromquelle mit den Halbbrücken;
einen Stromphasenausgangsanschluss (43) zum Verbinden einer Last mit den Halbbrücken;
eine Leiterplatten-(PCB)-Steuerung (100) mit einer Steuerschaltung, die betreibbar ist, um die Halbbrücken ein- und auszuschalten, um die Last mit der Stromquelle zu verbinden bzw. zu trennen;
Steueranschlüsse (44) zum Verbinden der Steuerschaltung auf der PCB mit einer Schaltung außerhalb des Leistungsschalters;
wobei die Halbbrücken, die PCB, die Steueranschlüsse, die Stromanschlüsse und der Stromphasenausgangsanschluss in derselben Einkapselungshülle (22) eingekapselt sind, die eine ebene erste Stirnfläche (23) und mindestens eine Randfläche (25) aufweist;
wobei alle Anschlüsse elektrische Kontaktflächen (30-1, 30-2, 30-3, 30-4) aufweisen, die auf und nur auf der ersten Fläche (23) freiliegen, und alle der mindestens einen Randfläche (25) frei von elektrischen Kontaktflächen und Anschlussstiften sind.

2. Elektrischer Leistungsschalter nach Anspruch 1, wobei die Kontaktflächen (30-1, 30-2, 30-3, 30-4) der Stromanschlüsse und des Stromphasenausgangsanschlusses im Wesentlichen bündig mit der ersten Stirnfläche sind.

3. Elektrischer Leistungsschalter nach Anspruch 1, wobei eine elektrische Kontaktfläche der Stromanschlüsse (30-1, 30-2) und/oder des Stromphasenausgangsanschlusses (30-3) relativ zur Ebene der ersten Stirnfläche erhöht oder vertieft ist.

4. Elektrischer Leistungsschalter nach einem der Ansprüche 1-3, wobei die Kontaktflächen der Steueranschlüsse (30-4) im Wesentlichen bündig mit der ersten Stirnfläche (23) sind.

5. Elektrischer Leistungsschalter nach Anspruch 4, wobei eine elektrische Kontaktfläche eines Steueranschlusses der Steueranschlüsse (30-4) relativ zur Ebene der ersten Stirnfläche (23) erhöht oder vertieft ist.

6. Elektrischer Leistungsschalter nach einem der Ansprüche 1-5, wobei die Kontaktfläche und der Steueranschluss, zu dem die Fläche gehört, konfiguriert sind, um mit einem elektrischen Leiter durch Löten, Ultraschall- oder Laserschweißen oder Einpressen oder Schrauben des Leiters in ein Loch im Steueranschluss gekoppelt zu werden.

7. Elektrischer Leistungsschalter nach einem der Ansprüche 1-6, wobei die Einkapselungshülle (22) ein rechteckiges Parallelepiped ist, das alle Komponenten des Schalters einkapselt.

8. Elektrischer Leistungsschalter (20), umfassend:
ein Paar im Wesentlichen paralleler Halbbrücken (70, 80);
Stromanschlüsse (41, 42) zum Koppeln einer Stromquelle mit den Halbbrücken;
einen Stromphasenausgangsanschluss (43) zum Verbinden einer Last mit den Halbbrücken;
eine Leiterplatten-(PCB)-Steuerung (100) mit einer Steuerschaltung, die betreibbar ist, um die Halbbrücken ein- und auszuschalten, um die Last mit der Stromquelle zu verbinden bzw. zu trennen;
erste und zweite Sätze (46, 48) von Steueranschlussstiften (48, 49), die einen elektrischen Kontakt mit der Steuerschaltung auf der PCB-Steuerung (100) herstellen;
eine Einkapselungshülle (22), die alle Komponenten des Schalters mit Ausnahme der Steueranschlussstifte (48, 49) einkapselt und eine Form eines rechteckigen Parallelepiped aufweist, das eine ebene erste Stirnfläche (23) und Randflächen (25) aufweist;
wobei die Kontaktflächen (30-1, 30-2) der Stromanschlüsse (41, 42) auf der ersten Stirnfläche freiliegen, und die ersten und zweiten Sätze (46, 48) von Steueranschlussstiften (48, 49) sich jeweils von ersten und zweiten gegenüberliegenden Randflächen (25) an diagonal gegenüberliegenden Stellen erstrecken, so dass normale Projektionen der Sätze auf eine selbe Ebene parallel zu den Ebenen der ersten und zweiten Ränder sich nicht überlappen.

9. Elektrischer Leistungsschalter nach einem der vorhergehenden Ansprüche und umfassend eine zweite Stirnfläche (24) gegenüber der ersten Stirnfläche und mit einer darauf ausgebildeten leitfähigen thermischen Schnittstelle (26).

10. Elektrischer Leistungsschalter nach einem der vorhergehenden Ansprüche, wobei, wenn der Schalter eingeschaltet ist, Strom zu dem Stromphasenausgangsanschluss (43) parallel zu einer selben Richtung in jeder Halbbrücke (70, 80) fließt.

11. Elektrischer Leistungsschalter nach einem der vorhergehenden Ansprüche und mit einer Gesamtleistungsschleifeninduktivität beim Übergang zwischen EIN- und AUS-Zuständen von weniger als etwa 2,5 nH, weniger als etwa 2,25 nH oder weniger als etwa 2,0 nH.

12. Leistungspackanordnung (201, 202), umfassend eine Mehrzahl von elektrischen Leistungsschaltern nach einem der vorhergehenden Ansprüche, die aneinander stoßen.

## Revendications

1. Commutateur de puissance électrique (20) comprenant :
une paire de demi-ponts sensiblement parallèles (70, 80) ;
des bornes d'alimentation (41, 42) pour coupler une source d'alimentation aux demi-ponts ;
une borne de sortie de phase d'alimentation (43) pour connecter une charge aux demi-ponts ;
un contrôleur de carte de circuit imprimé (PCB) (100) ayant des circuits de commande opérables pour activer et désactiver les demi-ponts pour connecter et déconnecter respectivement la charge à la source d'alimentation ;
des bornes de commande (44) pour connecter les circuits de commande sur la PCB à des circuits externes au commutateur de puissance ;
dans lequel les demi-ponts, la PCB, les bornes de commande, les bornes d'alimentation et la borne de sortie de phase d'alimentation sont encapsulés dans une même enveloppe d'encapsulation (22) ayant une première surface de front plane (23) et au moins une surface de bord (25) ;
dans lequel les bornes ont des surfaces de contact électrique (30-1, 30-2, 30-3, 30-4) qui sont exposées sur et seulement sur la première surface (23) et la totalité de l'au moins une surface de bord (25) sont dépourvues de surfaces de contact électrique et de broches de borne.

2. Commutateur de puissance électrique selon la revendication 1, dans lequel les surfaces de contact (30-1, 30-2, 30-3, 30-4) des bornes d'alimentation et de la borne de sortie de phase d'alimentation sont sensiblement de niveau avec la première surface de front.

3. Commutateur de puissance électrique selon la revendication 1, dans lequel une surface de contact électrique des bornes d'alimentation (30-1, 30-2) et/ou de la borne de sortie de phase d'alimentation (30-3) est surélevée ou en retrait par rapport au plan de la première surface de front.

4. Commutateur de puissance électrique selon l'une quelconque des revendications 1 à 3, dans lequel les surfaces de contact des bornes de commande (30-4) sont sensiblement de niveau avec la première surface de front (23).

5. Commutateur de puissance électrique selon la revendication 4, dans lequel une surface de contact électrique d'une borne de commande des bornes de commande (30-4) est surélevée ou en retrait par rapport au plan de la première surface de front (23).

6. Commutateur de puissance électrique selon l'une quelconque des revendications 1 à 5, dans lequel la surface de contact et la borne de commande à laquelle la surface appartient sont configurées pour être couplées à un conducteur électrique par brasage, soudage par ultrasons ou laser, ou raccordement par pression ou vissage du conducteur dans un trou dans la borne de commande.

7. Commutateur de puissance électrique selon l'une quelconque des revendications 1 à 6, dans lequel l'enveloppe d'encapsulation (22) est un parallélépipède rectangle qui encapsule tous les composants du commutateur.

8. Commutateur de puissance électrique (20) comprenant :
une paire de demi-ponts sensiblement parallèles (70, 80) ;
des bornes d'alimentation (41, 42) pour coupler une source d'alimentation aux demi-ponts ;
une borne de sortie de phase d'alimentation (43) pour connecter une charge aux demi-ponts ;
un contrôleur de carte de circuit imprimé (PCB) (100) ayant des circuits de commande opérables pour activer et désactiver les demi-ponts pour connecter et déconnecter respectivement la charge à la source d'alimentation ;
des premier et second ensembles (46, 48) de broches de borne de commande (48, 49) qui établissent un contact électrique avec des circuits de commande sur le contrôleur de PCB (100) ;
une enveloppe d'encapsulation (22) qui encapsule tous les composants du commutateur à l'exception des broches de borne de commande (48, 49) et a une forme d'un parallélépipède rectangle ayant une première surface de front plane (23) et des surfaces de bord (25) ;
dans lequel, les surfaces de contact (30-1, 30-2) des bornes d'alimentation (41, 42) sont exposées sur la première surface de front, et les premier et second ensembles (46, 48) de broches de borne de commande (48, 49) s'étendent respectivement à partir des première et seconde surfaces de bord opposées (25) à des emplacements diagonalement opposés de sorte que des projections normales des ensembles sur un même plan parallèle aux plans des premier et second bords ne se chevauchent pas.

9. Commutateur de puissance électrique selon l'une quelconque des revendications précédentes et comprenant une seconde surface de front (24) opposée à la première surface de front et ayant formée sur celle-ci une interface thermique conductrice (26).

10. Commutateur de puissance électrique selon l'une quelconque des revendications précédentes, dans lequel lorsque le commutateur est activé, un courant circule vers la borne de sortie de phase d'alimentation (43) parallèlement à une même direction dans chaque demi-pont (70, 80).

11. Commutateur de puissance électrique selon l'une quelconque des revendications précédentes et ayant une inductance de boucle de puissance totale lorsqu'une transition entre des états activé et désactivé est inférieure à environ 2,5 nH, ou inférieure à environ 2,25 nH ou inférieure à environ 2,0 nH.

12. Réseau de blocs d'alimentation (201, 202) comprenant une pluralité de commutateurs de puissance électrique selon l'une quelconque des revendications précédentes en butée les uns contre les autres.
